# FASCICULE DE BREVET EUROPEEN

(11) **EP 4 327 369 B1**
(45) Date de publication et mention de la délivrance du brevet: **01.01.2025**
(21) Numéro de dépôt: 22720442.7
(22) Date de dépôt: 04.04.2022
(51) Int. Cl.: H01L 31/18

(54) **PROCÉDÉ DE FABRICATION D'UN DISPOSITIF OPTOÉLECTRONIQUE COMPORTANT UN EMPILEMENT À PUITS QUANTIQUES MULTIPLES**
VERFAHREN ZUR HERSTELLUNG EINER OPTOELEKTRONISCHEN VORRICHTUNG MIT EINEM STAPEL AUS MEHREREN QUANTENTÖPFEN
PROCESS FOR MANUFACTURING AN OPTOELECTRONIC DEVICE COMPRISING A STACK OF MULTIPLE QUANTUM WELLS

(30) Priorité: 20.04.2021 FR 2104097
(43) Date de publication de la demande: 28.02.2024
(73) Titulaire: Commissariat à l'Energie Atomique et aux Energies Alternatives, 75015 Paris (FR)
(72) Inventeur: DUPONT, Florian, 38054 Grenoble Cedex 09 (FR)
(74) Mandataire: Cabinet Beaumont
(86) Numéro de dépôt international: PCT/EP2022/058878
(87) Numéro de publication internationale: WO 2022/223272

(56) Documents cités:
- WO-A1-2016/203724
- WO-A1-2018/231909
- CN-A- 109 962 172

## Description

La présente demande est basée sur, et revendique la priorité de, la demande de brevet français N°FR2104097 déposée le 20 avril 2021 et ayant pour titre " Dispositif optoélectronique comportant un empilement à puits quantiques multiples".

### Domaine technique

La présente description concerne de façon générale les dispositifs optoélectroniques, et vise plus particulièrement un procédé de fabrication d'un dispositif optoélectronique comportant un empilement à puits quantiques multiples.

### Technique antérieure

Divers dispositifs optoélectroniques comportant des empilements à puits quantiques multiples ont été proposés.

Un empilement à puits quantiques multiples est une structure de confinement de photons, permettant de contrôler la longueur d'onde d'émission ou d'absorption d'un dispositif optoélectronique. Un tel empilement comprend typiquement une alternance de couches semiconductrices d'un premier matériau et de couches semiconductrices d'un deuxième matériau, chaque couche du premier matériau étant prise en sandwich entre deux couches du deuxième matériau, le premier matériau ayant une bande interdite plus étroite que celle du deuxième matériau.

Le document WO 2018/231909 A1 décrit un dispositif optoélectronique et son procédé de fabrication, le dispositif comportant un empilement comprenant une alternance d'au moins une couche semiconductrice d'un premier matériau pérovskite inorganique et de couches semiconductrices d'un deuxième matériau inorganique, chaque couche du premier matériau étant prise en sandwich entre deux couches du deuxième matériau et définissant un puits quantique.

Il serait souhaitable d'améliorer au moins en partie certains aspects des dispositifs optoélectroniques comportant des empilements à puits quantiques multiples.

### Résumé de l'invention

L'invention est définie dans les revendications annexées, et concerne un procédé de fabrication d'un dispositif optoélectronique comportant un empilement comprenant une alternance d'au moins une couche semiconductrice d'un premier matériau et de couches semiconductrices d'un deuxième matériau, chaque couche du premier matériau étant prise en sandwich entre deux couches du deuxième matériau et définissant un puits quantique, dans lequel :
- le premier matériau est un matériau pérovskite inorganique ; et
- le deuxième matériau est un matériau semiconducteur inorganique.

Selon un mode de réalisation, le deuxième matériau comprend un composé III-V.

Selon un mode de réalisation, le premier matériau est un matériau pérovskite halogène inorganique.

Selon un mode de réalisation, le deuxième matériau comprend un composé III-N.

Selon un mode de réalisation, chaque couche du premier matériau a une épaisseur comprise entre 1 et 20 nm.

Selon un mode de réalisation, chaque couche du deuxième matériau a une épaisseur comprise entre 1 et 100 nm.

Selon l'invention, chaque couche du premier matériau a une structure cristalline alignée sur la structure cristalline de la couche sous-jacente du deuxième matériau, selon une relation d'épitaxie.

Selon l'invention le dispositif comporte en outre une LED, l'empilement à puits quantiques multiples étant disposé sur une face de la LED et étant adapté à convertir la lumière émise par la LED.

Selon un mode de réalisation, la LED comprend une couche active émissive prise en sandwich entre une couche semiconductrice dopée d'un premier type de conductivité et une couche semiconductrice dopée d'un deuxième type de conductivité, et l'empilement à puits quantiques multiples revêt une face de la couche semiconductrice dopée du deuxième type de conductivité opposée à la couche active émissive.

Selon un mode de réalisation, la couche active émissive de la LED comprend un empilement à puits quantiques multiples.

Selon un exemple ne faisant pas partie de l'invention, l'empilement à puits quantiques multiples constitue une couche active émissive d'une LED.

Selon un mode de réalisation, la LED comprend en outre une couche de transport d'électrons du côté d'une face de l'empilement à puits quantiques multiples et une couche de transport de trous du côté d'une autre face de l'empilement à puits quantiques multiples.

Selon un mode de réalisation, la couche de transport d'électrons et la couche de transport de trous sont en des matériaux semiconducteurs inorganiques.

Selon un mode de réalisation, la couche de transport d'électrons est en dioxyde de titane et la couche de transport de trous est en oxyde de nickel ou en Spiro-OMeTAD.

Selon un mode de réalisation, l'empilement comprend une pluralité de couches semiconductrices du premier matériau.

Dans le procédé selon l'invention,
les couches du premier matériau et les couches du deuxième matériau sont déposées successivement dans une même chambre de dépôt de telle manière que chaque couche du premier matériau a une structure cristalline alignée sur la structure cristalline de la couche sous-jacente du deuxième matériau, selon une relation d'épitaxie.

Selon un mode de réalisation, les couches du premier matériau et les couches du deuxième matériau sont déposées par dépôt laser pulsé.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en coupe représentant de façon schématique un empilement à puits quantiques multiples utilisé dans le cadre du procédé de fabrication d'un dispositif optoélectronique selon l'invention.
la figure 2 est une vue en coupe représentant de façon schématique un exemple d'un dispositif optoélectronique comportant un empilement à puits quantiques multiples; et
la figure 3 est une vue en coupe représentant de façon schématique un autre exemple d'un dispositif optoélectronique comportant un empilement à puits quantiques multiples.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation complète des dispositifs optoélectroniques décrits n'a pas été détaillée, la réalisation de ces dispositifs étant à la portée de la personne du métier à partir des indications de la présente description. Par la suite, seule la réalisation d'empilements à puits quantiques multiples des dispositifs optoélectroniques décrits a été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

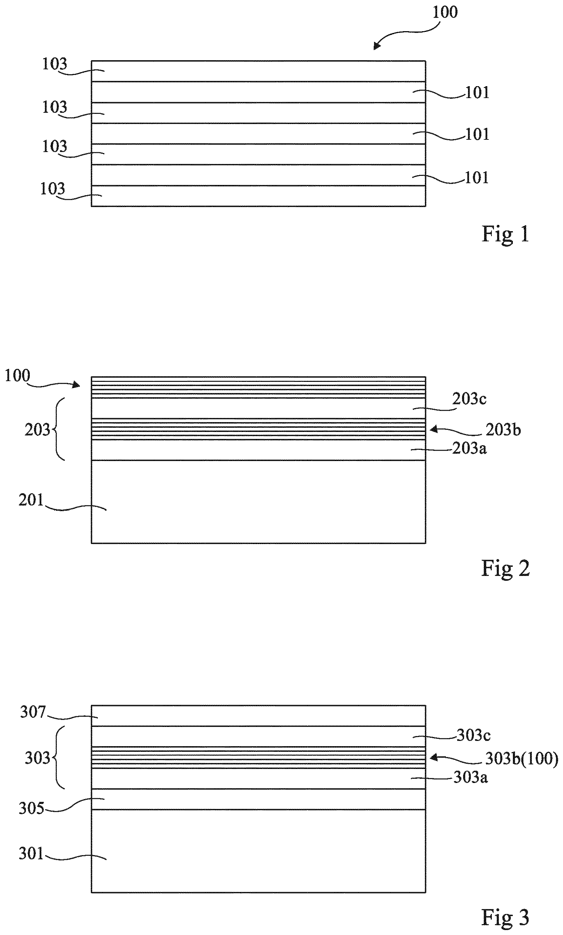

La figure 1 est une vue en coupe représentant de façon schématique un empilement à puits quantiques multiples 100 utilisé dans le cadre du procédé de fabrication d'un dispositif optoélectronique selon l'invention,

L'empilement 100 comprend une alternance d'une ou plusieurs couches semiconductrices 101 d'un premier matériau et de couches semiconductrices 103 d'un deuxième matériau, chaque couche 101 du premier matériau étant prise en sandwich entre deux couches 103 du deuxième matériau. Plus particulièrement, chaque couche 101 est en contact, par sa face inférieure, avec la face supérieure d'une couche 103, et, par sa face supérieure, avec la face inférieure d'une autre couche 103. Ainsi, si N désigne le nombre de couches 101, le nombre de couches 103 est égal à N+1.

Le matériau des couches 101 présente une bande interdite plus étroite que celle du matériau des couches 103.

Chaque première couche 101 définit un puits quantique. Les couches 103 sont des barrières quantiques.

Le nombre N de puits quantiques de l'empilement est de préférence supérieur ou égal à 2. Dans l'exemple représenté, N est égal à 3. Les modes de réalisation décrits ne se limitent toutefois pas à ce cas particulier. A titre de variante, le nombre N de puits quantiques de l'empilement peut être supérieur à 3.

Un tel empilement à puits quantiques multiples peut par exemple être utilisé comme élément de conversion photoluminescent dans un dispositif émissif, par exemple un écran d'affichage d'images ou un dispositif d'éclairage. Dans ce cas, l'empilement est placé en vis-à-vis d'une face d'émission d'une source lumineuse, par exemple une diode électroluminescente. L'empilement est alors adapté à absorber des photons à la longueur d'onde émission de la source lumineuse, et à réémettre des photons à une autre longueur d'onde.

Dans un exemple ne faisant pas partie de la présente invention, un empilement à puits quantiques multiples du type décrit en relation avec la figure 1 peut être utilisé comme couche active (auto-émissive) d'une source lumineuse, par exemple une diode électroluminescente.

Selon l'invention, le matériau des couches 101 est un matériau à structure pérovskite.

Un avantage est que les matériaux à structure pérovskite, appelés ci-après matériaux pérovskites, présentent une efficacité quantique interne élevée, pouvant aller jusqu'à 100%.

Un autre avantage est que les matériaux pérovskites présentent un coefficient d'absorption élevé.

Un autre avantage est que les matériaux pérovskites peuvent être déposés à des températures relativement basses, par exemple inférieures à 400°C, ce qui permet notamment leur dépôt au-dessus d'un circuit intégré de type CMOS (de l'anglais "Complementary Métal Oxide Semiconductor" - métal oxyde semiconducteur complémentaire).

Du fait des faibles épaisseurs requises pour assurer les fonctions de conversion ou d'émission lumineuse recherchées, les couches 101 et 103 peuvent être gravées facilement, ce qui permet de réaliser des éléments de conversion ou d'émission lumineuse présentant de très petites dimensions latérales.

Il en résulte que les empilements à puits quantiques multiples à base de matériaux pérovskites sont particulièrement avantageux pour la réalisation d'éléments de conversion ou d'émission lumineuse dans des pixels de petites dimensions, par exemple pour la réalisation d'écrans d'affichage d'images couleur présentant un pas inter-pixel inférieur à 100 µm, par exemple inférieur à 20 µm, voire inférieur à 5 pm.

Pour obtenir de bonnes performances de conversion ou d'émission lumineuse et une durée de vie importante, le matériau des couches 101 est un matériau pérovskite inorganique.

A titre d'exemple, on pourra utiliser un matériau pérovskite à base de césium, de plomb et d'un ou plusieurs halogènes, par exemple du CsPbI₂Br, du CsPbBr₃, du CsPbCl₃, ou encore du CsPbI₃. A titre de variante, on pourra utiliser un matériau pérovskite de type MAPbI₃. Plus généralement, d'autres matériaux pérovskites peuvent être choisis en fonction des propriétés de conversion ou d'émission recherchées.

De façon générale, on utilisera de préférence un matériau pérovskite dit halogène inorganique, c'est-à-dire de type ABX₃, où :
- A est un élément inorganique, par exemple du césium (Cs), du plomb (Pb), du phosphore (K) ou du lithium (Li),
- B est du plomb (Pb) de l'étain (Sn) ou du germanium (Ge), et
- X est un halogène, par exemple le brome (Br), le chlore (Cl), l'iode (I) ou une combinaison d'halogènes.

Le matériau des couches barrières 103 est un matériau semiconducteur inorganique. De façon préférentielle, le matériau des couches 103 comprend un composé III-V comprenant au moins un premier élément du groupe III, un deuxième élément du groupe V, et, éventuellement, un troisième élément, par exemple un élément du groupe III autre que le premier élément. A titre d'exemple, l'élément du groupe V est l'azote (N). Autrement dit, le matériau des couches 103 comprend un composé III-N. A titre d'exemple, le matériau des couches 103 est du nitrure de gallium (GaN), du nitrure d'aluminium (AlN), du nitrure de bore (BN), du nitrure d'indium (InN) ou un alliage d'un ou plusieurs de ces matériaux.

L'empilement de la figure 1 est formé par croissance épitaxiale. Ceci permet d'obtenir des couches 101 monocristallines, qui présentent l'avantage d'être plus stables dans le temps que des couches pérovskites polycristallines. En outre, l'encapsulation des couches 101 par des couches 103 inorganiques épitaxiées permet d'améliorer la stabilité dans le temps du matériau pérovskite, notamment en évitant une exposition à l'oxygène du matériau pérovskite. De plus, la réalisation de l'empilement par croissance épitaxiale permet de créer des contraintes dans les couches 101 et 103, ce qui permet d'améliorer la stabilité dans le temps des couches 101 de matériau pérovskite, notamment en prévenant la ségrégation des halogènes sous l'effet de l'exposition à la lumière.

De façon préférentielle, les couches 101 et 103 de l'empilement sont déposées successivement par dépôt PLD (de l'anglais "Pulsed Laser Déposition" - dépôt laser pulsé) aussi appelé dépôt par ablation laser pulsée. Le dépôt PLD consiste à pulvériser ou ablater la surface d'une cible du matériau à déposer au moyen d'un laser pulsé, de manière à transférer le matériau dans un plasma, puis, via le plasma, sur le substrat de destination. Un avantage du dépôt PLD est qu'il permet de déposer des matériaux complexes tels que les matériaux pérovskites avec une bonne qualité cristalline, et ce à une température relativement basse, par exemple inférieure à 400°C, sans endommager le substrat de destination. Les couches 101 et 103 sont successivement déposées par PLD sans changer d'équipement de dépôt et sans extraire le substrat destination de la chambre de dépôt entre deux étapes successives de dépôt. En effet, un avantage du dépôt PLD est qu'il permet de commuter entre différentes cibles de matériaux de compositions différentes sans extraire le substrat destination de la chambre de dépôt. Ceci permet de ne pas exposer à l'air ou à l'oxygène les différentes couches de l'empilement entre les dépôts successifs. Un autre avantage est que le dépôt PLD est une méthode de dépôt douce. Autrement dit, le dépôt PLD se caractérise par un atterrissage doux ("soft landing" en anglais) des atomes de la cible sur le substrat destination. Ceci permet en particulier de ne pas endommager le matériau pérovskite des couches 101 lors du dépôt des couches barrières 103.

L'épaisseur des couches 101 est choisie de façon à permettre un confinement quantique dans chaque couche 101. A titre d'exemple, chaque couche 101 présente une épaisseur comprise entre 1 et 20 nm. Chaque couche barrière 103 présente par exemple une épaisseur comprise entre 1 et 100 nm.

La figure 2 est une vue en coupe représentant de façon schématique un exemple d'un dispositif optoélectronique comportant un empilement à puits quantiques multiples 100 du type décrit en relation avec la figure 1. Le dispositif de la figure 2 est une cellule émissive à LED, définissant par exemple un pixel d'un écran d'affichage émissif à LED.

Le dispositif de la figure 2 comprend un substrat de support 201, par exemple en saphir ou en silicium, et une LED 203 disposée sur la face supérieure du substrat 201. Dans cet exemple, la LED 203 comprend un empilement comportant, dans l'ordre à partir de la face supérieure du substrat 201, une couche semiconductrice 203a dopée d'un premier type de conductivité, une couche active émissive 203b, et une couche semiconductrice 203c dopée d'un second type de conductivité. Dans cet exemple, les couches 203a et 203c sont dopées respectivement de type N et de type P et forment respectivement la cathode et l'anode de la LED 203. A titre de variante, les couches 203a et 203c peuvent être interverties. Dans cet exemple, la couche émissive 203b est un empilement de puits quantiques multiples constitué d'une alternance de couches de puits quantiques d'un premier matériau et de couches barrières d'un deuxième matériau. A titre d'exemple, chacun des premier et deuxième matériaux comprend majoritairement un composé III-V comprenant au moins un premier élément du groupe III, un deuxième élément du groupe V, et, éventuellement, un troisième élément, par exemple un élément du groupe III autre que le premier élément. Chaque puits quantique est par exemple en nitrure de gallium. Dans l'exemple représenté, la couche 203b est en contact, par sa face inférieure, avec la face supérieure de la couche 203a, et, par sa face supérieure, avec la face inférieure de la couche 203c.

Dans le dispositif de la figure 2, l'empilement 100 est disposé sur la face supérieure de la LED 203. Dans cet exemple, l'empilement 100 est un empilement de conversion photoluminescent adapté à absorber des photons à la longueur d'onde émission de la LED 203, et à réémettre des photons à une autre longueur d'onde. Ceci permet de convertir la lumière émise par la LED 203. On obtient ainsi une cellule émissive émettant à une longueur d'onde différente de la longueur d'onde d'émission de la LED 203.

A titre d'exemple ne faisant pas partie de la présente invention, les couches 203a, 203b et 203c de la LED 203 sont formées successivement par épitaxie, par exemple par MOCVD (de l'anglais "Metalorganic Chemical Vapour Déposition" - dépôt chimique en phase vapeur aux organométalliques), sur la face supérieure du substrat 201. L'empilement 100 peut ensuite être formé par dépôt PLD sur et en contact avec la face supérieure de la couche 203c.

Selon la présente invention, après la formation de l'empilement de LED 203, ce dernier peut être reporté sur un substrat de report, plus précisément un circuit intégré de contrôle des LED, par exemple un circuit CMOS (mode de réalisation non représentée). Dans ce cas, la face supérieure (dans l'orientation de la figure 2) de couche 203c est tournée vers le substrat de report et accolée à une face du substrat de report. Le substrat de croissance 201 peut ensuite être retiré, de façon à exposer la face de la couche 203a opposée au substrat de report. L'empilement 100 peut ensuite être formé par dépôt PLD sur et en contact avec la face de la couche 203c opposée au substrat de report.

A titre d'exemple, non limitatif, la LED 203 est adaptée à émettre majoritairement de la lumière bleue, et l'empilement 100 est adapté à convertir la lumière bleue émise par la LED en lumière majoritairement rouge. Pour cela, les couches de puits quantiques 101 de l'empilement 100 sont par exemple en CsPbI3, par exemple d'épaisseur de l'ordre de 7 nm, et les couches barrières 103 de l'empilement 100 sont par exemple en GaN, par exemple en GaN non intentionnellement dopé, par exemple d'épaisseur de l'ordre de 15 nm.

À titre d'exemple ne faisant pas partie de la présente invention, la figure 3 est une vue en coupe représentant de façon schématique un dispositif optoélectronique comportant un empilement à puits quantiques multiples 100 du type décrit en relation avec la figure 1. La encore, le dispositif de la figure 3 est une cellule émissive à LED, définissant par exemple un pixel d'un écran d'affichage émissif à LED.

Le dispositif de la figure 3 comprend un substrat de support 301, par exemple en saphir ou en silicium, et une LED 303 disposée sur la face supérieure du substrat 301. Dans cet exemple, la LED 303 comprend un empilement comportant, dans l'ordre à partir de la face supérieure du substrat 301, une première couche de transport de charges 303a, une couche active émissive 303b, et une deuxième couche de transport de charges 303c. Dans cet exemple, la couche émissive 303b est constituée par un empilement de puits quantiques multiples 100 à base de matériau pérovskite du type décrit en relation avec la figure 1. Dans l'exemple représenté, la couche 303b est en contact, par sa face inférieure, avec la face supérieure de la couche 303a, et, par sa face supérieure, avec la face inférieure de la couche 303c. A titre d'exemple, la couche 303a est une couche de transport d'électrons et la couche 303c est une couche de transport de trous. La couche 303a est par exemple en dioxyde de titane (TiO₂). La couche 303c est par exemple en oxyde de nickel (NiO). A titre de variante, la couche 303c est en Spiro-OMeTAD (C₈₁H₆₈N₄O₈). Les couches 303a et 303c permettent d'injecter du courant dans l'empilement 100 de façon à provoquer l'émission de lumière par la LED. A titre de variante, les couches 303a et 303c peuvent être inversées.

Dans l'exemple de la figure 3, le dispositif comprend en outre une couche métallique réfléchissante 305, aussi appelée couche miroir, entre la face supérieure du substrat 301 et la LED 303. Plus particulièrement, dans l'exemple représenté, la couche 305 est en contact, par sa face inférieure, avec la face supérieure du substrat 301, et, par sa face supérieure, avec la face inférieure de la couche 303a. La couche 305 est par exemple en platine. La couche 305 permet de renvoyer la lumière émise par la LED en direction de la face d'émission du dispositif, à savoir sa face supérieure dans cet exemple. La couche 305 forme en outre, dans cet exemple, une électrode inférieure de la LED.

Dans l'exemple de la figure 3 le dispositif comprend en outre une couche conductrice 307, transparente à la longueur d'onde d'émission de la LED, disposée du côté de la face supérieure de la couche 303c, par exemple sur et en contact avec la face supérieure de la couche 303c. La couche conductrice 307 forme une électrode supérieure de la LED. La couche 307 est par exemple en un oxyde conducteur transparent, par exemple en oxyde d'indium-étain (ITO), ou en oxyde de zinc (ZNO). La couche 307 peut être dopée à l'aluminium ou au cadmium. La couche 307 peut être recouverte d'une couche de passivation, non représentée, par exemple en nitrure de silicium.

On obtient ainsi une cellule émissive émettant à une longueur d'onde fonction de la composition de l'empilement à puits quantiques multiples 100. A titre d'exemple, non limitatif, la LED 303 est adaptée à émettre majoritairement de la lumière rouge. Pour cela, les couches de puits quantiques 101 de l'empilement 100 sont par exemple en CsPbI3, par exemple d'épaisseur de l'ordre de 7 nm, et les couches barrières 103 de l'empilement 100 sont par exemple en GaN, par exemple en GaN non intentionnellement dopé, par exemple d'épaisseur de l'ordre de 15 nm.

A titre d'exemple, les couches 305 et 303a sont d'abord formées successivement sur la face supérieure du substrat 301, par exemple par dépôt ALD (de l'anglais "Atomic Layer Déposition" - dépôt en couches monoatomiques) ou par toute autre méthode de dépôt adaptée. L'empilement 100 peut ensuite être formé sur la face supérieure de la couche 303a, par exemple par dépôt PLD. Les couches 303c et 307 sont ensuite formées successivement sur la face supérieure de l'empilement 100, par exemple par dépôt ALD ou par toute autre méthode de dépôt adaptée.

Bien que l'on ait décrit ci-dessus des exemples d'intégration d'empilements à puits quantiques multiples à base de matériaux pérovskites dans des dispositifs émissifs à base de LED planaires, les modes de réalisation pourront être adaptés à des dispositifs émissifs à base de LED tridimensionnelles, par exemple des LED à base de nanofils ou de microfils semiconducteurs, ou encore des LED pyramidales, par exemple micro ou nano pyramidales, par exemple du type décrit dans la demande de brevet FR3087942 ou dans la demande de brevet FR3089687 précédemment déposées par le demandeur. Une étape de planarisation de la surface du dispositif peut optionnellement être prévue avant le dépôt de l'empilement à puits quantiques multiples à base d'un matériau pérovskite. Par exemple, si l'empilement à puits quantiques multiples à base d'un matériau pérovskite est un convertisseur quantique, ce dernier peut être déposé soit directement sur les LED tridimensionnelles, soit sur la surface supérieure d'une couche de planarisation transparente préalablement déposée sur les LED tridimensionnelles.

Par ailleurs, bien que l'on ait décrit ci-dessus uniquement des exemples de réalisation dans lesquels les couches barrières 103 de l'empilement à puits quantiques multiples à base d'un matériau pérovskite est en un composé III-V, les modes de réalisation décrits ne se limitent pas à ce cas particulier. Plus généralement, les couches 103 peuvent être en tout matériau semiconducteur inorganique, par exemple un matériau IV-IV, par exemple du carbure du silicium (SiC), ou encore un matériau II-VI, par exemple de l'oxyde de zinc (ZnO) .

## Revendications

1. Procédé de fabrication d'un dispositif optoélectronique comportant un circuit intégré de contrôle et, du côté d'une face dudit circuit intégré, un empilement (100) comprenant une alternance d'au moins une couche semiconductrice (101) d'un premier matériau et de couches semiconductrices (103) d'un deuxième matériau, chaque couche (101) du premier matériau étant prise en sandwich entre deux couches (103) du deuxième matériau et définissant un puits quantique, le premier matériau étant un matériau pérovskite inorganique, et le deuxième matériau étant un matériau semiconducteur inorganique, le dispositif comportant en outre une LED (203) sur ladite face du circuit intégré de contrôle, l'empilement (100) à puits quantiques multiples étant disposé sur une face de la LED (203) opposée au circuit intégré de contrôle et étant adapté à convertir la lumière émise par la LED (203),
dans lequel les couches (101) du premier matériau et les couches (103) du deuxième matériau sont déposées successivement dans une même chambre de dépôt de telle manière que chaque couche (101) du premier matériau a une structure cristalline alignée sur la structure cristalline de la couche (103) sous-jacente du deuxième matériau, selon une relation d'épitaxie,
le procédé comprenant une étape de report de la LED (203) sur ladite face du circuit intégré de contrôle, l'empilement (100) étant déposé sur la face de la LED (203) opposée au circuit intégré de contrôle, après ladite étape de report.

2. Procédé selon la revendication 1, dans lequel le deuxième matériau comprend un composé III-V.

3. Procédé selon la revendication 1 ou 2, dans lequel le premier matériau est un matériau pérovskite halogène inorganique.

4. Procédé selon l'une quelconque des revendications 1 à 3 dans lequel le deuxième matériau comprend un composé III-N.

5. Procédé selon l'une quelconque des revendications 1 à 4, dans lequel chaque couche (101) du premier matériau a une épaisseur comprise entre 1 et 20 nm.

6. Procédé selon l'une quelconque des revendications 1 à 5, dans lequel chaque couche (103) du deuxième matériau a une épaisseur comprise entre 1 et 100 nm.

7. Procédé selon l'une quelconque des revendications 1 à 6, dans lequel la LED (203) comprend une couche active émissive (203b) prise en sandwich entre une couche semiconductrice (203a) dopée d'un premier type de conductivité et une couche semiconductrice (203c) dopée d'un deuxième type de conductivité, et dans lequel l'empilement (100) à puits quantiques multiples revêt une face de la couche semiconductrice (203b) dopée du deuxième type de conductivité opposée à la couche active émissive (203b).

8. Procédé selon la revendication 7, dans lequel la couche active émissive (203b) de la LED (203) comprend un empilement à puits quantiques multiples.

9. Procédé selon l'une quelconque des revendications 1 à 8, dans lequel l'empilement (100) comprend une pluralité de couches semiconductrices (101) du premier matériau.

10. Procédé selon l'une quelconque des revendications 1 à 9, dans lequel les couches (101) du premier matériau et les couches (103) du deuxième matériau sont déposées par dépôt laser pulsé.

## Patentansprüche

1. Verfahren zur Herstellung einer optoelektronischen Vorrichtung, aufweisend eine integrierte Steuerschaltung und auf einer Seite der integrierten Schaltung einen Stapel (100), der eine Abfolge von mindestens einer Halbleiterschicht (101) aus einem ersten Material und Halbleiterschichten (103) aus einem zweiten Material aufweist, wobei jede Schicht (101) des ersten Materials zwischen zwei Schichten (103) des zweiten Materials angeordnet ist und einen Quantentopf definiert, wobei das erste Material ein anorganisches Perowskit-Material ist und das zweite Material ein anorganisches Halbleitermaterial ist, wobei die Vorrichtung ferner eine LED (203) auf der Fläche der integrierten Steuerschaltung aufweist, wobei der Stapel aus mehreren Quantentöpfen (100) auf einer Fläche der LED (203) entgegengesetzt zur integrierten Steuerschaltung angeordnet ist und so angepasst ist, dass er das von der LED (203) emittierte Licht umwandelt,
wobei Schichten (101) des ersten Materials und Schichten (103) des zweiten Materials nacheinander in derselben Abscheidungskammer so abgeschieden werden, dass jede Schicht (101) des ersten Materials eine Kristallstruktur aufweist, die mit der Kristallstruktur der darunterliegenden Schicht (103) des zweiten Materials in einer epitaktischen Beziehung ausgerichtet ist,
wobei das Verfahren einen Schritt des Übertragens der LED (203) auf die Fläche der integrierten Steuerschaltung aufweist, wobei der Stapel (100) nach dem Übertragungsschritt auf der Fläche der LED (203) entgegengesetzt zur integrierten Steuerschaltung abgeschieden wird.

2. Verfahren nach Anspruch 1, wobei das zweite Material eine III-V-Verbindung aufweist.

3. Verfahren nach Anspruch 1 oder 2, wobei das erste Material ein anorganisches Halogen-Perowskit-Material ist.

4. Verfahren nach einem der Ansprüche 1 bis 3, wobei das zweite Material eine III-N-Verbindung aufweist.

5. Verfahren nach einem der Ansprüche 1 bis 4, wobei jede Schicht (101) des ersten Materials eine Dicke zwischen 1 und 20 nm aufweist.

6. Verfahren nach einem der Ansprüche 1 bis 5, wobei jede Schicht (103) des zweiten Materials eine Dicke zwischen 1 und 100 nm aufweist.

7. Verfahren nach einem der Ansprüche 1 bis 6, wobei die LED (203) eine emittierende aktive Schicht (203b) aufweist, die zwischen einer Halbleiterschicht (203a), die mit einem ersten Leitfähigkeitstyp dotiert ist, und einer Halbleiterschicht (203c), die mit einem zweiten Leitfähigkeitstyp dotiert ist, angeordnet ist, und wobei der Mehrfach-Quantentopf-Stapel (100) eine Fläche der mit dem zweiten Leitfähigkeitstyp dotierten Halbleiterschicht (203b) gegenüber der emittierenden aktiven Schicht (203b) beschichtet.

8. Verfahren nach Anspruch 7, wobei die aktive emittierende Schicht (203b) der LED (203) einen Mehrfach-Quantentopf-Stapel aufweist.

9. Verfahren nach einem der Ansprüche 1 bis 8, wobei der Stapel (100) eine Vielzahl von Halbleiterschichten (101) des ersten Materials aufweist.

10. Verfahren nach einem der Ansprüche 1 bis 9, wobei die Schichten (101) des ersten Materials und die Schichten (103) des zweiten Materials durch gepulste Laserabscheidung abgeschieden werden.

## Claims

1. A method of manufacturing an optoelectronic device comprising a control integrated circuit and, on one side of said integrated circuit, a stack (100) comprising an alternation of at least one semiconductor layer (101) of a first material and of semiconductor layers (103) of a second material, each layer (101) of the first material being sandwiched between two layers (103) of the second material and defining a quantum well, the first material being an inorganic perovskite material, and the second material being an inorganic semiconductor material, the device further comprising an LED (203) on said face of the control integrated circuit, the multiple quantum well stack (100) being disposed on a face of the LED (203) opposite the control integrated circuit and being adapted to convert the light emitted by the LED (203),
in which layers (101) of the first material and layers (103) of the second material are deposited successively in the same deposition chamber in such a way that each layer (101) of the first material has a crystal structure aligned with the crystal structure of the underlying layer (103) of the second material, according to an epitaxial relationship, the method comprising a step of transferring the LED (203) onto said face of the integrated control circuit, the stack (100) being deposited on the face of the LED (203) opposite the integrated control circuit, after said transfer step.

2. The method of claim 1, wherein the second material comprises a III-V compound.

3. The method of claim 1 or 2, wherein the first material is an inorganic halogen perovskite material.

4. A method according to any one of claims 1 to 3 in which the second material comprises a III-N compound.

5. A method according to any one of claims 1 to 4, wherein each layer (101) of the first material has a thickness of between 1 and 20 nm.

6. A method according to any one of claims 1 to 5, wherein each layer (103) of the second material has a thickness of between 1 and 100 nm.

7. A method according to any of claims 1 to 6, wherein the LED (203) comprises an emissive active layer (203b) sandwiched between a semiconductor layer (203a) doped with a first conductivity type and a semiconductor layer (203c) doped with a second conductivity type, and wherein the multi-quantum-well stack (100) coats a face of the semiconductor layer (203b) doped with the second conductivity type opposite the emissive active layer (203b).

8. The method according to claim 7, wherein the active emissive layer (203b) of the LED (203) comprises a multiple quantum well stack.

9. A method according to any one of claims 1 to 8, wherein the stack (100) comprises a plurality of semiconductor layers (101) of the first material.

10. A method according to any one of claims 1 to 9, in which the layers (101) of the first material and the layers (103) of the second material are deposited by pulsed laser deposition.
